# EUROPEAN PATENT APPLICATION

(11) **EP 3 276 824 A1**
(43) Date of publication of application: **31.01.2018**
(21) Application number: 16767994.3
(22) Date of filing: 14.03.2016
(51) Int. Cl.: H02S 40/36, H02S 30/20

(54) **PHOTOELECTRIC CONVERSION DEVICE**

(30) Priority: 25.03.2015 JP 2015062644
(71) Applicant: Zeon Corporation, Tokyo 100-8246 (JP)
(72) Inventor: YOSHIDA, Masayoshi, Tokyo 100-8246 (JP); KOJIMA, Kiyoshige, Tokyo 100-8246 (JP); HAYASHI, Yuki, Tokyo 100-8246 (JP); YAMAAI, Midori, Tokyo 100-8246 (JP); YOSHIWARA, Akihiko, Tokyo 100-8246 (JP)
(74) Representative: Maiwald Patentanwalts GmbH
(86) International application number: PCT/JP2016/001443
(87) International publication number: WO 2016/152086

(57) **Abstract**

Provided is a photoelectric conversion device that enables simple and more reliable connection of a solar cell module to a main body capable of supplying electrical power to an external device. The photoelectric conversion device includes: a photoelectric conversion module group (10) including a first connection means (12); and a main body part (20) including a second connection means (21) that is mechanically and electrically connectable to the first connection means (12). The first connection means (12) includes a first connecting portion (121) and a first connector (122). The second connection means (21) includes a second connecting portion (211) that slides against and engages with the first connecting portion (121) and a second connector (212) that connects to the first connector (122) when the first connecting portion (121) is at a specific position. One of the first connecting portion (121) and the second connecting portion (211) is a guide rail (211) and the other is a guide (121) that slides against and engages with the guide rail (211).

## Description

### TECHNICAL FIELD

This disclosure relates to a photoelectric conversion device.

### BACKGROUND

In recent years, there has been increased demand for portable power generating devices that enable users to use portable devices such as smartphones, notebook personal computers (PCs), and tablet PCs even when they go out and do not have access to a commercial power supply.

In one example, PTL 1 discloses, as a transportable power generating device, a foldable, sheet-shaped solar battery including a plurality of solar cells. A pair of leads are connected to this sheet-shaped solar battery, and by inserting terminals disposed at the tips of these leads, into a power supplier, electrical power can be supplied to an electrical device from the power supplier.

### CITATION LIST

### Patent Literature

PTL 1: JP H9-51118 A

### SUMMARY

### (Technical Problem)

However, since the terminals disposed at the tips of the pair of leads must each be inserted into the power supplier in the configuration described in PTL 1, the described configuration necessitates two terminal insertion operations. Therefore, the configuration described in PTL 1 is inconvenient because the sheet-shaped solar battery cannot be connected to the power supplier through a single operation.

Moreover, since the configuration described in PTL 1 is a configuration in which the terminals of the leads are inserted into the power supplier, these leads tend to become detached from the power supplier if pulling force is applied to the leads. Therefore, in the configuration described in PTL 1, the connection between the sheet-shaped solar battery and the power supplier is unreliable.

In view of the points set forth above, an objective of this disclosure is to provide a photoelectric conversion device that enables simple connection of a solar cell module to a main body capable of supplying electrical power to an external device and that enables more reliable connection between the solar cell module and the main body.

Moreover, the techniques disclosed herein conform with one aspect of first and second connection means in Japanese Patent Application No. 2015-059752, which was separately filed by the inventors, and is based on a technical concept of "compatibility assurance" that is not suggested at all by PTL 1 or other prior technical documents. The effects of the disclosed techniques can benefit from the effects of the separately filed Japanese Patent Application No. 2015-059752 and can also contribute to this separately filed application.

### (Solution to Problem)

This disclosure aims to advantageously solve the problems set forth above by disclosing a photoelectric conversion device comprising: a photoelectric conversion module group including a first connection means; and a main body part including a second connection means that is mechanically and electrically connectable to the first connection means, wherein the first connection means includes a first connecting portion and a first connector, the second connection means includes a second connecting portion that is configured to slide against and engage with the first connecting portion and a second connector that is configured to connect to the first connector in a state in which the first connecting portion is at a specific position, and one of the first connecting portion and the second connecting portion is a guide rail and the other of the first connecting portion and the second connecting portion is a guide that slides against and engages with the guide rail. Accordingly, the presently disclosed photoelectric conversion device enables easy mechanical and electrical connection of the photoelectric conversion module group to the main body part through a simple operation of sliding and engaging the first connecting portion and the second connecting portion. Moreover, the presently disclosed photoelectric conversion device enables more reliable connection between the photoelectric conversion module group and the main body part due to the sliding and engaging of the first connecting portion and the second connecting portion.

In the presently disclosed photoelectric conversion device, the first connecting portion and the first connector are preferably bound together as an integrated structure. This configuration can simplify the configuration of the first connection means.

Moreover, in the presently disclosed photoelectric conversion device, the second connecting portion and the second connector are preferably bound together as an integrated structure. This configuration can simplify the configuration of the second connection means.

Furthermore, in the presently disclosed photoelectric conversion device, the photoelectric conversion module group preferably includes a plurality of photoelectric conversion modules in cascade connection. This configuration enables a greater electrical power supply to be received.

Also, in the presently disclosed photoelectric conversion device, in a case in which the first connecting portion is a guide and the second connecting portion is a guide rail, it is preferable that the first connector is disposed at a tip of the first connecting portion and the second connector is disposed at an innermost part of the second connecting portion, and in a case in which the first connecting portion is a guide rail and the second connecting portion is a guide, it is preferable that the first connector is disposed at an innermost part of the first connecting portion and the second connector is disposed at a tip of the second connecting portion. This configuration enables simple mechanical and electrical connection of the photoelectric conversion module group and the main body part through insertion of the guide to the innermost part of the guide rail.

In the presently disclosed photoelectric conversion device, the first connection means may include a plurality of the first connecting portion and a plurality of the first connector, and the second connection means may include a plurality of the second connecting portion and a plurality of the second connector.

Moreover, in the presently disclosed photoelectric conversion device, the guide preferably has a cross-sectional shape that is vertically asymmetric. This configuration can prevent reverse insertion of the guide into the guide rail.

Furthermore, in the presently disclosed photoelectric conversion device, the guide rail preferably has a guide groove in a side surface at one side thereof. This configuration enables reduction of the height direction thickness of the guide rail.

Also, in the presently disclosed photoelectric conversion device, it is preferable that the first connecting portion is a guide and the second connecting portion is a guide rail, and that a securing reinforcement member that is configured to secure the first connecting portion is disposed on the main body part. This configuration enables secure holding of the photoelectric conversion module group after the photoelectric conversion module group is attached to the main body part.

Moreover, in the presently disclosed photoelectric conversion device, the securing reinforcement member and the first connecting portion are preferably electrically connected through a contacting portion of the securing reinforcement member and the first connecting portion. This configuration enables secure mechanical holding of the photoelectric conversion module group by the securing reinforcement member while also enabling electrical connection of the photoelectric conversion module group and the main body part through the securing reinforcement member.

Furthermore, in the presently disclosed photoelectric conversion device, the first connector preferably includes a lock mechanism that is configured to lock the first connection means and the second connection means in a state in which the first connection means and the second connection means are mechanically and electrically connected. This configuration can prevent connector detachment.

The presently disclosed photoelectric conversion device preferably further comprises a support means configured to support the photoelectric conversion device in a suspended manner. This configuration enables space-saving during set-up because it is not necessary to open out the photoelectric conversion module group in a plane on a desk, or the like, during set-up of the photoelectric conversion device.

Moreover, in the presently disclosed photoelectric conversion device, the first connector and the second connector preferably include at least one electrode terminal. This configuration enables various shapes to be selected for the first connector and the second connector.

In the presently disclosed photoelectric conversion device, the photoelectric conversion module group preferably includes a photoelectric conversion module that is an organic solar cell module. This enables weight-reduction of the photoelectric conversion device and can increase portability.

Moreover, the presently disclosed photoelectric conversion device is preferably an organic solar cell power generating device. This enables weight-reduction of the photoelectric conversion device and can improve portability.

In the presently disclosed photoelectric conversion device, the photoelectric conversion module group may include a photoelectric conversion module that is an inorganic solar cell module.

Moreover, the presently disclosed photoelectric conversion device may be an inorganic solar cell power generating device.

Furthermore, in the presently disclosed photoelectric conversion device, the photoelectric conversion module group may include a photoelectric conversion module that is a solar cell module in which at least one electrode has a plastic material as a base.

### (Advantageous Effect)

The presently disclosed photoelectric conversion device enables simple connection of a solar cell module to a main body capable of supplying electrical power to an external device and enables more reliable connection between the solar cell module and the main body.

### BRIEF DESCRIPTION OF THE DRAWINGS

In the accompanying drawings:
FIG. 1 is a block diagram illustrating configuration of a photoelectric conversion device according to a disclosed embodiment;
FIG. 2 is a block diagram illustrating configuration of a solar cell module group illustrated in FIG. 1;
FIG. 3 illustrates configuration of a photoelectric conversion device according to a first embodiment;
FIGS. 4A and 4B illustrate the appearance of attachment of a solar cell module group to a main body part of the photoelectric conversion device according to the first embodiment;
FIG. 5 illustrates the appearance when a solar cell module group including a plurality of solar cell modules is connected to the main body part of the photoelectric conversion device according to the first embodiment;
FIG. 6 is a flowchart illustrating an example of an operation of charging a rechargeable battery of a photoelectric conversion device;
FIG. 7 is a flowchart illustrating an example of an operation of discharging to an external device from a photoelectric conversion device;
FIG. 8 illustrates configuration of a photoelectric conversion device according to modified example 1;
FIGS. 9A and 9B illustrate the appearance of attachment of a solar cell module group to a main body part in the photoelectric conversion device according to modified example 1;
FIG. 10 illustrates the appearance when a solar cell module group including a plurality of solar cell modules is connected to the main body part in the photoelectric conversion device according to modified example 1;
FIG. 11 illustrates configuration of a photoelectric conversion device according to modified example 2;
FIGS. 12A and 12B illustrate the appearance of attachment of a solar cell module group to a main body part in the photoelectric conversion device according to modified example 2;
FIG. 13 illustrates the appearance when a solar cell module group including a plurality of solar cell modules is connected to the main body part of the photoelectric conversion device according to modified example 2;
FIG. 14 illustrates configuration of a photoelectric conversion device according to modified example 3;
FIGS. 15A and 15B illustrate configuration of a photoelectric conversion device according to modified example 4;
FIG. 16 illustrates configuration of a photoelectric conversion device according to modified example 5;
FIG. 17 illustrates configuration of a photoelectric conversion device according to modified example 6;
FIG. 18 illustrates configuration of a photoelectric conversion device according to modified example 7;
FIG. 19 illustrates configuration of a photoelectric conversion device according to modified example 8;
FIG. 20 illustrates a first example of use of a photoelectric conversion device;
FIG. 21 illustrates the first example of use of a photoelectric conversion device; and
FIG. 22 illustrates a second example of use of a photoelectric conversion device.

### DETAILED DESCRIPTION

The following provides a description of disclosed embodiments.

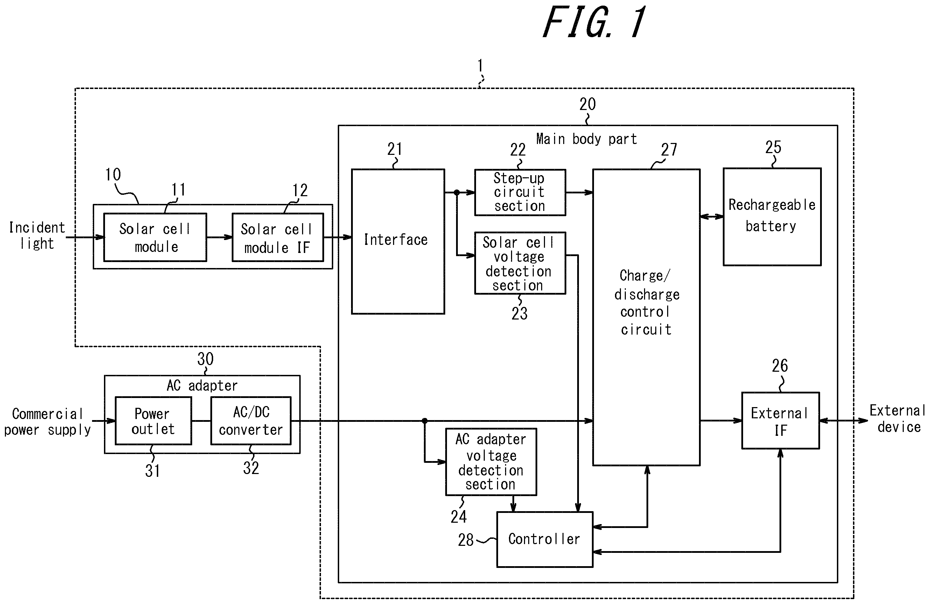

FIG. 1 is a block diagram illustrating configuration of a photoelectric conversion device 1 according to one disclosed embodiment.

The photoelectric conversion device 1 according to the present embodiment includes a solar cell module group (one or a plurality of photoelectric conversion module groups) 10 and a main body part 20. In the photoelectric conversion device 1, the solar cell module group 10, which includes at least one solar cell module, is attached to the main body part 20, and the main body part 20 is configured to receive an electrical power supply from the solar cell module group 10 (solar cell module). The main body part 20 may accumulate the supplied electrical power in the device or may supply the electrical power to a smartphone, tablet PC, or other external device via a specific interface, such as a universal serial bus (USB) interface. The photoelectric conversion device 1 can also receive an electrical power supply from a commercial power supply via an AC adapter 30. The AC adapter 30 includes a power outlet 31 and an AC/DC converter 32. The AC/DC converter 32 is configured to receive input of an AC voltage from the commercial power supply, via the power outlet 31, convert the input AC voltage to a DC voltage, and supply the DC voltage to the main body part 20.

The solar cell module group 10 includes at least one solar cell module 11 and a solar cell module interface (IF) 12.

The solar cell module 11 is a photoelectric conversion module including at least one solar cell that photoelectrically converts incident light, such as sunlight or room light, and outputs electrical power.

In terms of type, solar cells are broadly classified as inorganic solar cells in which an inorganic material is used and organic solar cells in which an organic material is used. Examples of inorganic solar cells include Si solar cells in which Si is used and compound solar cells in which a compound is used. Examples of organic solar cells include thin-film solar cells such as small molecule vapor deposition-type solar cells in which an organic pigment is used, polymer coating-type solar cells in which a conductive polymer is used, and coating-conversion-type solar cells in which a conversion-type semiconductor is used; and dye-sensitized solar cells formed from titania, an organic dye, and an electrolyte. Other examples of solar cells include organic/inorganic hybrid solar cells and solar cells in which a perovskite compound is used. Herein, any of these types of solar cells can be used. However, organic solar cells are generally suitable for use herein since organic solar cells can be provided with a thin and flexible configuration.

At least one electrode of the solar cell module 11 may have a plastic material as a base.

The solar cell module IF (first connection means) 12 is an interface for attaching the solar cell module group 10 to the main body part 20 and providing mechanical and electrical connection therebetween. The solar cell module IF 12 is described in detail further below.

The main body part 20 includes an interface 21, a step-up circuit section 22, a solar cell voltage detection section 23, an AC adapter voltage detection section 24, a rechargeable battery 25, an external interface (IF) 26, a charge/discharge control circuit 27, and a controller 28.

The interface 21 (second connection means) attaches the solar cell module group 10 to the main body part 20 and provides mechanical and electrical connection (linkage) therebetween. The interface 21 is configured to receive a voltage supplied from the attached solar cell module group 10 (solar cell module 11), via the solar cell module IF 12, and supply the voltage to the step-up circuit section 22. The interface 21 is described in detail further below.

The step-up circuit section 22 is configured to receive a voltage supplied from the solar cell module group 10, via the interface 21, raise the supplied voltage to a specific voltage required for charging the rechargeable battery 25, and output the raised voltage to the charge/discharge control circuit 27.

The solar cell voltage detection section 23 is configured to detect a voltage (solar cell voltage) that is supplied to the step-up circuit section 22, via the interface 21, from the solar cell module group 10 (solar cell module 11) attached to the main body part 20, and output the result of the detection to the controller 28.

The AC adapter voltage detection section 24 is configured to detect a voltage (AC adapter voltage) that is supplied to the charge/discharge control circuit 27 from the AC adapter 30, and output the result of the detection to the controller 28.

The rechargeable battery 25 is a battery that can be charged and discharged, such as a lead-acid battery or a lithium ion secondary battery.

The external IF 26 is, for example, an interface such as a USB interface for connecting the photoelectric conversion device 1 to an external device.

The charge/discharge control circuit 27 is configured to control charging and discharging between the step-up circuit section 22, the AC adapter 30, the rechargeable battery 25, and the external device connected via the external IF 26.

The controller 28 is configured to control operation of each section of the main body part 20. For example, the controller 28 controls the charge/discharge control circuit 27 to control paths for charging and discharging based on the detection result of the solar cell voltage detection section 23, the detection result of the AC adapter voltage detection section 24, and the charge level of the rechargeable battery 25. Moreover, the controller 28, for example, controls voltage-raising operation of the step-up circuit section 22.

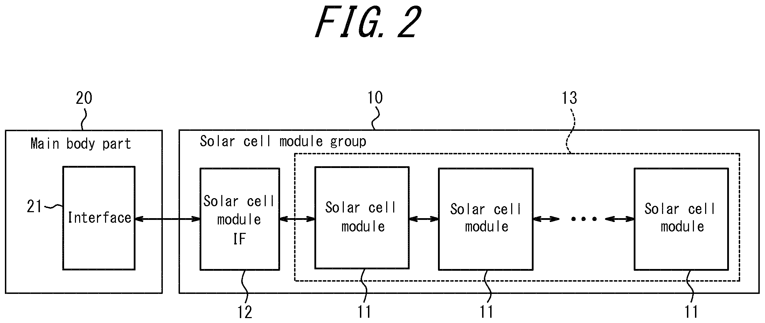

Next, configuration of the solar cell module group 10 is described in more detail with reference to the block diagram illustrated in FIG. 2.

The solar cell module group 10 illustrated in FIG. 2 includes a solar cell module set 13 and a solar cell module IF 12.

The solar cell module set 13 includes at least one solar cell module 11. In a situation in which the solar cell module set 13 includes a plurality of solar cell modules 11, the solar cell modules 11 are arranged with a specific spacing therebetween and adjacent solar cell modules 11 are in cascade connection. One of the solar cell modules 11 (solar cell module 11 positioned at one end of the column of solar cell modules 11 in the example illustrated in FIG. 2) is connected to the solar cell module IF 12. In a state in which the solar cell module group 10 is attached to the interface 21 of the main body part 20, the total of output voltages of the solar cell modules 11 included in the solar cell module set 13 is supplied to the main body part 20 via the solar cell module IF 12. The main body part 20 can receive an electrical power supply from the attached solar cell module group 10.

In a situation in which the solar cell module group 10 includes a plurality of solar cell modules 11, electrodes of the solar cell modules 11 are, for example, connected by a flexible substrate. Through this configuration, the solar cell module group 10 can be folded at a section between adjacent solar cell modules 11. Consequently, the solar cell module group 10 can be opened out during use and can be folded when not in use such as to facilitate storage and transport.

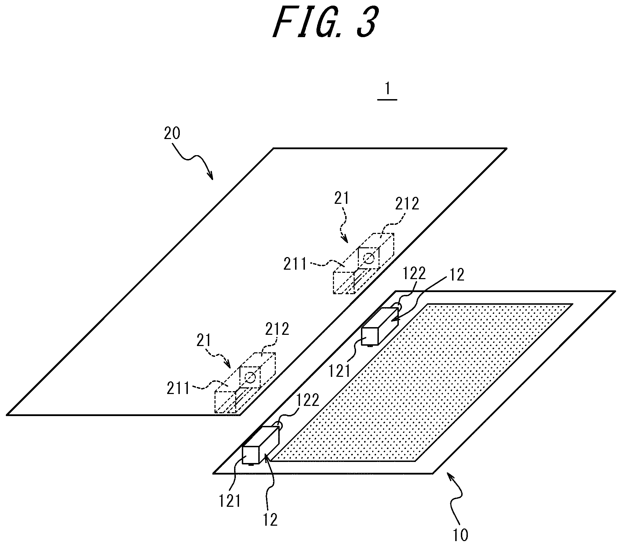

FIG. 3 illustrates configuration of a photoelectric conversion device 1 according to a first embodiment.

In the example illustrated in FIG. 3, two interfaces 21 are disposed at a rear surface of the main body part 20 of the photoelectric conversion device 1. Also, two solar cell module IFs 12 are disposed at a front surface of the solar cell module group 10. The shape of the solar cell module IFs 12 corresponds to the interfaces 21. By connecting the solar cell module group 10 to the interfaces 21 of the main body part 20 through the solar cell module IFs 12, it is possible to mechanically and electrically connect the solar cell module group 10 to the main body part 20 and to supply electrical power generated by the solar cell module 11 to the main body part 20.

Next, configuration of the solar cell module IFs 12 is described in detail.

The solar cell module IFs 12 each include a guide 121 (first connecting portion) and a connector 122 (first connector). The guide 121 and the connector 122 are bound together as an integrated structure as illustrated in FIG. 3. The guide 121 and the connector 122 are not limited by the shape of the solar cell module group 10 and a desired shape may be independently adopted therefor.

The guide 121 is a member having a specific shape, and has a columnar shape in the example illustrated in FIG. 3.

The connector 122 is attached to a tip of the guide 121 (end of the guide 121 in a backward direction relative to the plane of the drawing in FIG. 3). The guide 121 and the connector 122 are provided in an integrated form (i.e., the guide 121 and the connector 122 are bound together). The connector 122 is electrically connected to an electrode of one solar cell module 11 in the solar cell module set 13 of the solar cell module group 10. The connector 122 may, for example, be a male structure of a pin connector.

Next, configuration of the interfaces 21 is described.

The solar cell module group 10 can be connected to the interfaces 21 via the solar cell module IFs 12.

The interfaces 21 each include a guide rail 211 (second connecting portion) and a connector 212 (second connector). The guide rail 211 and the connector 212 are bound together as an integrated structure as illustrated in FIG. 3. The guide rail 211 and the connector 212 are not limited by the shape of the main body part 20 and a desired shape may be independently adopted therefor.

The guide rail 211 is a member having a shape that corresponds to the guide 121 of a corresponding solar cell module IF 12. The guide rail 211 can receive insertion of the guide 121 of the corresponding solar cell module IF 12 into a hollow portion thereof, and can be slid against (brought into contact with such as to slide) and engaged with the guide 121. In the example illustrated in FIG. 3, the guide 121 is inserted from the front of the corresponding guide rail 211, relative to the plane of the drawing, toward an inner part of the guide rail 211.

The connector 212 is disposed at a position such as to be connected to the connector 122 of the corresponding solar cell module IF 12 in a state in which the corresponding guide 121 is engaged with the guide rail 211 at a specific position. The term "specific position" refers, for example, to a position of the guide 121 and the connector 122 that corresponds to a predetermined positional relationship of the corresponding guide rail 211 and connector 212. For example, in the example illustrated in FIG. 3, the term "specific position" refers to a position at which the guide 121 is in a state of being pushed to the innermost part of the corresponding guide rail 211, which is a position at which the connector 122 is connected to the connector 212. The guide rail 211 and the connector 212 are provided in an integrated form (i.e., the guide 211 and the connector 212 are bound together). In the example illustrated in FIG. 3, the connector 212 is disposed at an innermost part of the guide rail 211. The connector 212 may, for example, be a female structure of a pin connector.

As illustrated in FIG. 3, the connector 122 of each of the solar cell module IFs 12 is disposed at the tip of the guide 121. In this case, the connector 212 of each of the interfaces 21 is, for example, disposed around an innermost part of the guide rail 211 such that the connector 122 and the connector 212 become connected when the corresponding guide 121 is inserted to the innermost part of the guide rail 211.

The engagement of the guides 121 and the guide rails 211 mechanically connects the solar cell module group 10 and the main body part 20. Moreover, the connection of the connectors 122 and the connectors 212 that accompanies the engagement of the guides 121 and the guide rails 211 electrically connects the solar cell module group 10 and the main body part 20. In this manner, the solar cell module group 10 and the main body part 20 can be mechanically and electrically connected in the present embodiment through a simple operation of sliding the guide 121 of each of the solar cell module IFs 12 along the guide rail 211 of the corresponding interface 21 such that the connector 122 that is connected to the guide 121 is guided into the corresponding connector 212.

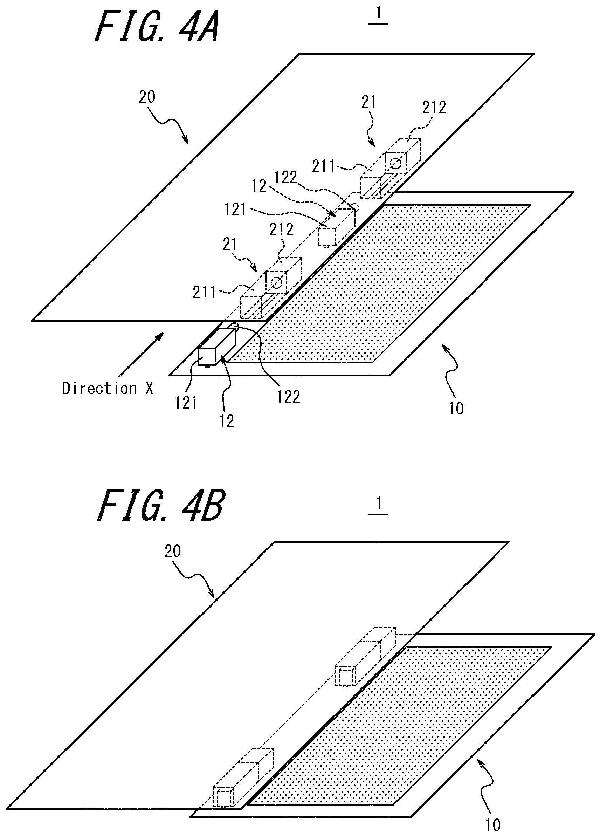

FIGS. 4A and 4B illustrate the appearance of attachment of the solar cell module group 10 to the main body part 20 according to the first embodiment. FIG. 4A illustrates the appearance directly before the guides 121 are slid along the guide rails 211. FIG. 4B illustrates the appearance when the guides 121 are pushed along the guide rails 211 to a specific position (innermost part), the connectors 122 and the connectors 212 are connected, and attachment of the solar cell module group 10 to the main body part 20 is complete.

As illustrated in FIGS. 4A and 4B, when the two guides 121 are simultaneously inserted into the two corresponding guide rails 211 and are then pushed to the innermost part thereof, the connectors 122 and the connectors 212 become connected.

This configuration enables one-touch (single operation) connection of the solar cell module group 10 to the main body part 20 and also enables one-touch disconnection by pulling the solar cell module group 10 out from the main body part 20. In other words, by adopting this configuration, the solar cell module group 10 can be easily attached to and detached from the main body part 20.

Moreover, the connectors 122 become connected to the connectors 212 in this configuration by pushing each of the guides 121 to the innermost part of the corresponding guide rail 211. In other words, when the solar cell module group 10 becomes mechanically connected to the main body part 20, the solar cell module group 10 simultaneously becomes electrically connected to the main body part 20.

The direction of insertion of the guides 121 into the guide rails 211 is indicated as direction X in FIG. 4A. Through this configuration, in a situation in which, for example, the main body part 20 is used in a suspended state, the solar cell module group 10 does not easily detach from the main body part 20 even though the weight of the solar cell module group 10 acts on the guides 121 and the guide rails 211.

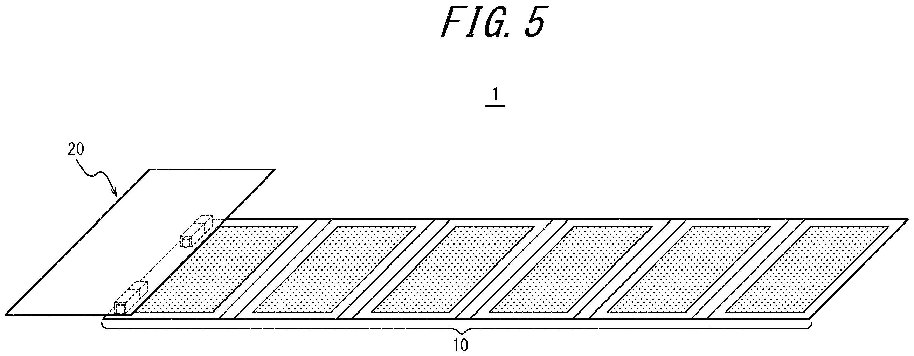

FIG. 5 illustrates the appearance when the solar cell module group 10 is connected to the main body part 20 according to the first embodiment for a case in which the solar cell module group 10 includes a plurality of solar cell modules 11.

As illustrated in FIG. 5, the solar cell module group 10 can be attached to and detached from the main body part 20 by one touch even in a case in which the solar cell module group 10 includes a plurality of solar cell modules 11. Moreover, by attaching a solar cell module group 10 including a plurality of solar cell modules 11 to the main body part 20 as described above, the main body part 20 can receive a greater supply of electrical power from the solar cell module group 10.

It should be noted that the shapes of the solar cell module IFs 12 and the interfaces 21 are not limited to those illustrated in FIG. 3, and various shapes may be adopted. In other words, the solar cell module IFs 12 and the interfaces 21 may have any shape so long as the guides 121 and the guide rails 211 can slide against and engage with one another. Other examples of the shapes of the solar cell module IFs 12 and the interfaces 21 are provided in the subsequently described modified examples 1 to 8.

Although an example is described in the present embodiment in which the guides 121 are included in the solar cell module IFs 12 and the guide rails 211 are included in the interfaces 21, this is not a limitation. Alternatively, a configuration may be adopted in which guide rails are included in the solar cell module IFs 12 and guides are included in the interfaces 21. The same also applies to the subsequently described modified examples 1 to 8.

Furthermore, although an example is described in the present embodiment in which two solar cell module IFs 12 are disposed at the front surface of the solar cell module group 10 and two interfaces 21 are disposed at the rear surface of the main body part 20, the number and positioning of the solar cell module IFs 12 and the interfaces 21 is not limited to this example. The choice of whether the solar cell module IFs 12 are disposed at the front surface or the rear surface of the solar cell module group 10 and whether the interfaces 21 are disposed at the front surface or the rear surface of the main body part 20 can be made as appropriate depending on the shapes of the guides 121 and the guide rails 211. The same also applies to the subsequently described modified examples 1 to 8.

The number, size, width, positioning, and so forth of the guides 121 and the guide rails 211 can also be freely selected without being limited by the shapes of the solar cell module group 10 and the main body part 20, so long as the guides and the guide rails can slide against and engage with one another. Accordingly, the shape and positioning of the guides 121 and the guide rails 211 can be appropriately selected with a high degree of freedom depending on the objective. For example, the shape and positioning of the guides 121 and the guide rails 211 may be selected such as to be compatible with miniaturization and thickness-reduction. A number of examples are provided in the subsequently described modified examples 1 to 8.

The number, positioning, and so forth of the connectors 122 and the connectors 212 can be freely set so long as the connectors 122 and the connectors 212 are connectable in a state in which the guides 121 and the guide rails 211 are engaged. Moreover, the number of electrode terminals (pins) connecting the connectors 122 and the connectors 212 may be any number.

Furthermore, although an example is described in the present embodiment in which the connectors 122 are each a male structure of a pin connector and the connectors 212 are each a female structure of a pin connector, this is not a limitation. Alternatively, the connectors 122 may each be a female structure of a pin connector and the connectors 212 may each be a male structure of a pin connector.

Next, operation of the photoelectric conversion device 1 according to the present embodiment is described.

The photoelectric conversion device 1 according to the present embodiment is configured to receive a request from an external device connected to the external IF 26 and supply electrical power to the external device via the external IF 26. There are three supply sources for supplying electrical power to the external device. These supply sources are the solar cell module group 10 attached to the main body part 20, the AC adapter 30, and the rechargeable battery 25 of the main body part 20. The photoelectric conversion device 1 is configured to select an appropriate supply source for supplying electrical power to the external device from among these supply sources and supply electrical power to the external device connected to the external IF 26.

Moreover, the photoelectric conversion device 1 according to the present embodiment is configured to charge the rechargeable battery 25 using the solar cell module group 10 attached to the main body part 20 or the AC adapter 30 as a supply source of electrical power. The photoelectric conversion device 1 is configured to select a suitable supply source for supplying electrical power to the rechargeable battery 25 from among these supply sources and charge the rechargeable battery 25.

The following describes operation of the photoelectric conversion device 1 during charging of the rechargeable battery 25 and during discharging to the external device. First, operation during charging of the rechargeable battery 25 is described.

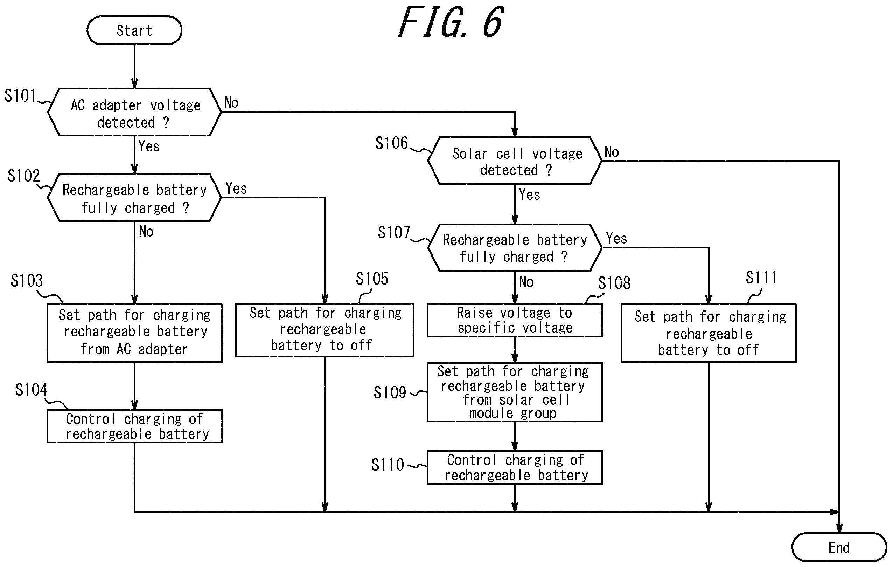

FIG. 6 is a flowchart illustrating operation of the photoelectric conversion device 1 during charging of the rechargeable battery 25.

The controller 28 determines whether or not an AC adapter voltage is detected from output of the AC adapter voltage detection section 24 (Step S101).

In a situation in which the controller 28 determines that an AC adapter voltage is detected (Step S101: Yes), the controller 28 determines whether or not the rechargeable battery 25 is fully charged (Step S102).

In a situation in which the controller 28 determines that the rechargeable battery 25 is not fully charged (Step S102: No), the controller 28 controls the charge/discharge control circuit 27 to set a path for charging of the rechargeable battery 25 from the AC adapter 30 (Step S103). The charge/discharge control circuit 27 controls charging of the rechargeable battery 25 in accordance with the set path (Step S104). It should be noted that description of methods for controlling charging of the rechargeable battery 25 is omitted since such methods are well known by persons of ordinary skill in the technical field and are not directly related to this disclosure.

In a situation in which the controller 28 determines that the rechargeable battery 25 is fully charged (Step S102: Yes), the controller 28 controls the charge/discharge control circuit 27 to set the path for charging of the rechargeable battery 25 to off (Step S105).

In a situation in which the controller 28 determines that an AC adapter voltage is not detected (Step S101: No), the controller 28 determines whether or not a solar cell voltage is detected from output of the solar cell voltage detection section 23 (Step S106).

In a situation in which the controller 28 determines that a solar cell voltage is detected (Step S106: Yes), the controller 28 determines whether or not the rechargeable battery 25 is fully charged (Step S107).

In a situation in which the controller 28 determines that the rechargeable battery 25 is not fully charged (Step S107: No), the controller 28 causes the step-up circuit section 22 to raise a voltage supplied from the solar cell module group 10 via the interfaces 21 (Step S108). In addition, the controller 28 controls the charge/discharge control circuit 27 to set a path for charging of the rechargeable battery 25 from the solar cell module group 10 (Step S109). The charge/discharge control circuit 27 controls charging of the rechargeable battery 25 in accordance with the set path (Step S110).

In a situation in which the controller 28 determines that the rechargeable battery 25 is fully charged (Step S107: Yes), the controller 28 controls the charge/discharge control circuit 27 to set the path for charging of the rechargeable battery 25 to off (Step Sill).

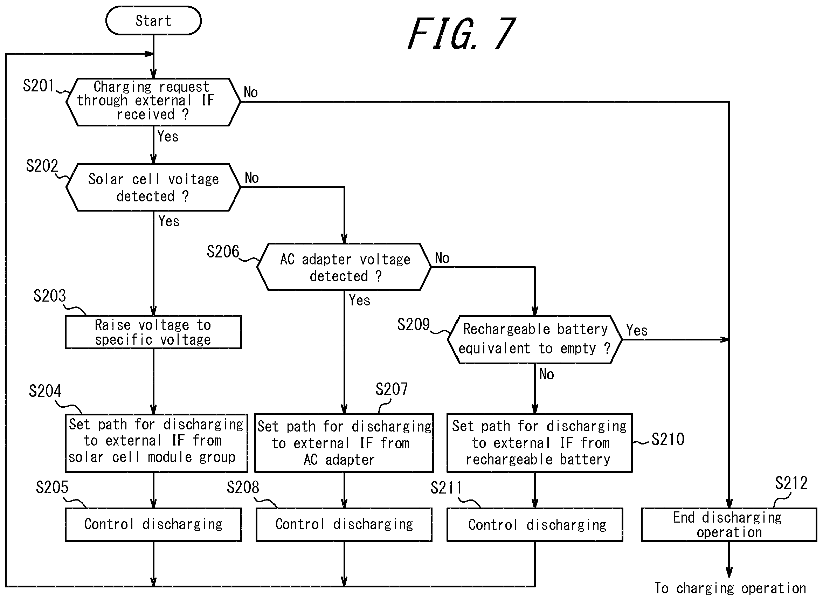

After the rechargeable battery 25 is fully charged through control of charging in Step S104 or Step S110, after the path for charging of the rechargeable battery 25 is set to off through processing in Step S105 or Step Sill, or in a situation in which the controller 28 determines that a solar cell voltage is not detected (Step S106: No), the controller 28 ends the charging operation and proceeds to a discharging operation illustrated in FIG. 7.

FIG. 7 is a flowchart illustrating operation of the photoelectric conversion device 1 during discharging to an external device.

First, the controller 28 determines whether or not a charging request is received from an external device via the external IF 26 (Step S201).

In a situation in which the controller 28 determines that there is a request for electrical power supply from an external device via the external IF 26 (Step S201: Yes), the controller 28 determines whether or not a solar cell voltage is detected from output of the solar cell voltage detection section 23 (Step S202).

In a situation in which the controller 28 determines that a solar cell voltage is detected (Step S202: Yes), the controller 28 causes the step-up circuit section 22 to raise a voltage supplied from the solar cell module group 10 via the interfaces 21 (Step S203). In addition, the controller 28 controls the charge/discharge control circuit 27 to set a path for discharging to the external IF 26 from the solar cell module group 10 (Step S204). The charge/discharge control circuit 27 controls discharging to the external IF 26 from the solar cell module group 10 in accordance with the set path (Step S205). As a result, electrical power is supplied to the external device from the solar cell module group 10, via the external IF 26. It should be noted that description of methods for controlling discharging to the external IF 26 is omitted since such methods are well known by persons of ordinary skill in the technical field and are not directly related to this disclosure.

In a situation in which the controller 28 determines that a solar cell voltage is not detected (Step S202: No), the controller 28 determines whether or not an AC adapter voltage is detected from output of the AC adapter voltage detection section 24 (Step S206).

In a situation in which the controller 28 determines that an AC adapter voltage is detected (Step S206: Yes), the controller 28 controls the charge/discharge control circuit 27 to set a path for discharging to the external IF 26 from the AC adapter 30 (Step S207). The charge/discharge control circuit 27 controls discharging to the external IF 26 from the AC adapter 30 in accordance with the set path (Step S208). As a result, electrical power is supplied to the external device from the AC adapter 30, via the external IF 26.

In a situation in which the controller 28 determines that an AC adapter voltage is not detected (Step S206: No), the controller 28 determines whether or not the charge level of the rechargeable battery 25 is equivalent to empty (Step S209).

In a situation in which the controller 28 determines that the charge level of the rechargeable battery 25 is not equivalent to empty (Step S209: No), the controller 28 controls the charge/discharge control circuit 27 to set a path for discharging to the external IF 26 from the rechargeable battery 25 (Step S210). The charge/discharge control circuit 27 controls discharging to the external IF 26 from the rechargeable battery 25 in accordance with the set path (Step S211). As a result, electrical power is supplied to the external device from the rechargeable battery 25, via the external IF 26.

After control of discharge by the charge/discharge control circuit 27 ends in Step S205, Step S208, or Step S211, the controller 28 returns to Step S201 and determines whether or not there is a charging request.

In a situation in which the controller 28 determines that a charging request is not received from an external device (Step S201: No) or in a situation in which the controller 28 determines that the charge level of the rechargeable battery 25 is equivalent to empty (Step S209: Yes), the controller 28 ends the discharging operation (Step S212) and returns to the charging operation illustrated in FIG. 6.

### (Modified example 1)

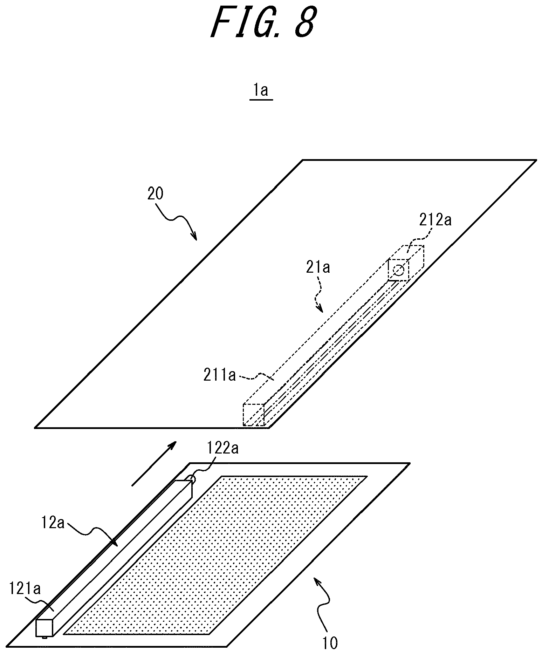

FIG. 8 illustrates configuration of a photoelectric conversion device 1a according to modified example 1.

The photoelectric conversion device 1a according to modified example 1 differs from the configuration of the photoelectric conversion device 1 according to the first embodiment illustrated in FIG. 3 in terms that only one interface 21a is disposed on the main body part 20 and only one solar cell module IF 12a is disposed on the solar cell module group 10.

The solar cell module IF 12a according to modified example 1 is longer than the solar cell module IFs 12 of the photoelectric conversion device 1 according to the first embodiment. Specifically, the length of the solar cell module IF 12a is almost as long as an edge of the solar cell module group 10 at which the solar cell module IF 12a is disposed.

Through this configuration, the photoelectric conversion device 1a according to modified example 1 has an effect of increasing the mechanical strength of the interface 21a and the solar cell module IF 12a in a situation in which the photoelectric conversion device 1a is suspended such that the direction in which a guide 121a and a guide rail 211a are slid is perpendicular to the direction of gravitational force.

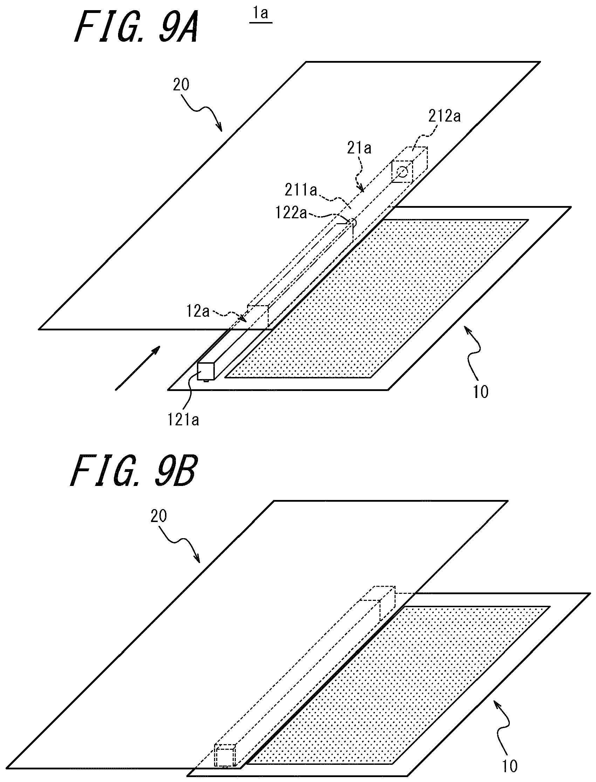

FIGS. 9A and 9B illustrate the appearance of attachment of the solar cell module group 10 to the main body part 20 according to modified example 1. FIG. 9A illustrates the appearance when the guide 121a is slid along the guide rail 211a. FIG. 9B illustrates the appearance when the guide 121a is pushed along the guide rail 211a to a specific position (innermost part), a connector 122a and a connector 212a are connected, and attachment of the solar cell module group 10 to the main body part 20 is complete.

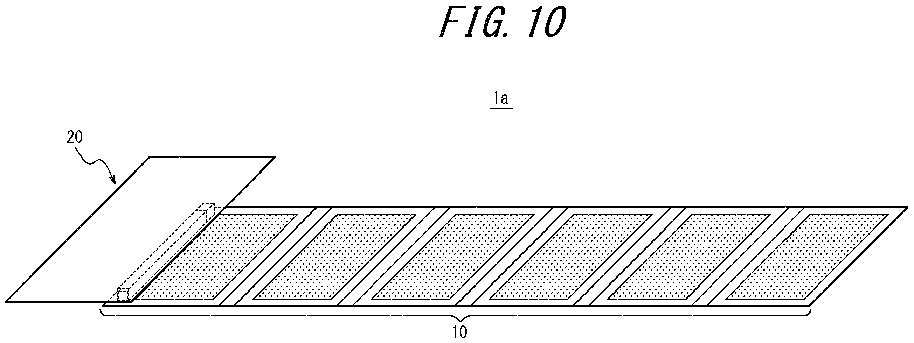

FIG. 10 illustrates the appearance when the solar cell module group 10 is connected to the main body part 20 according to modified example 1 in a case in which the solar cell module group 10 includes a plurality of solar cell modules 11.

It should be noted that the provision of just one interface 21 and one solar cell module IF 12 is a common feature of configuration in modified examples 2 to 8, and the long length of the solar cell module IF 12 is a common feature of configuration in modified examples 2 to 7. Therefore, description of these features is omitted in description of modified examples 2 to 8.

### (Modified example 2)

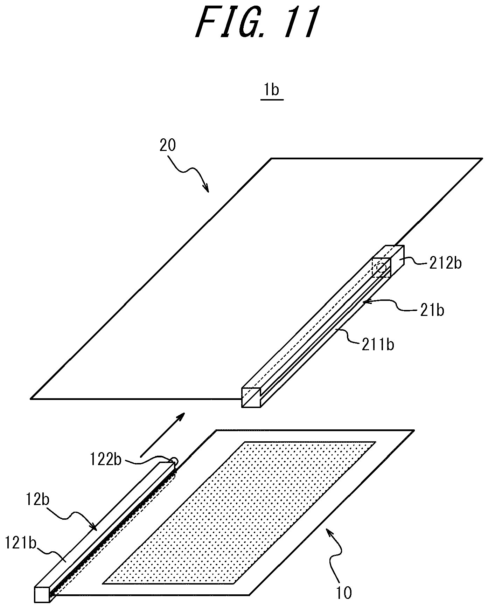

FIG. 11 illustrates configuration of a photoelectric conversion device 1b according to modified example 2.

An interface 21b according to modified example 2 is disposed at a side part of the main body part 20, rather than being disposed at the front surface or the rear surface of the main body part 20. Moreover, a solar cell module IF 12b is disposed at a side part of the solar cell module group 10, rather than being disposed at the front surface or the rear surface of the solar cell module group 10.

Through this configuration, the photoelectric conversion device 1b according to modified example 2 has an effect of enabling attachment of the solar cell module group 10 at the same height as the main body part 20.

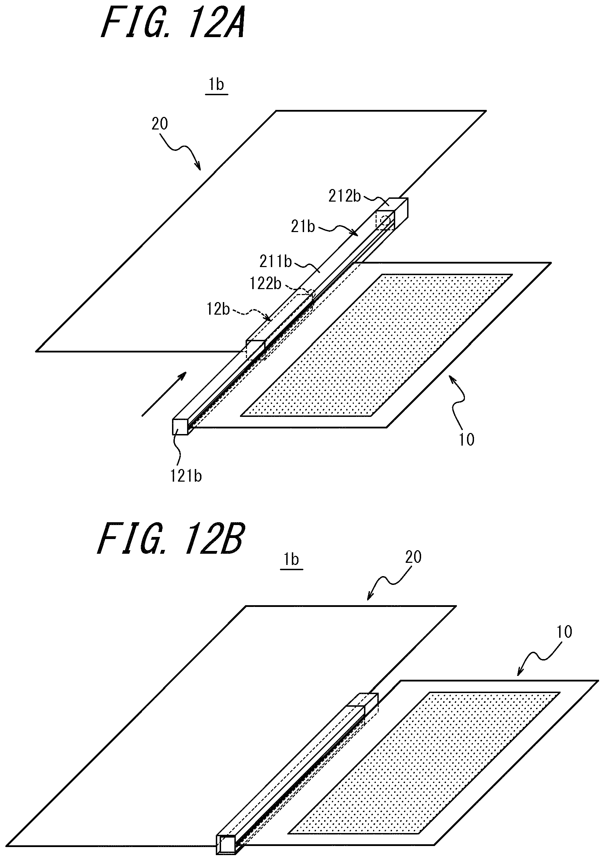

FIGS. 12A and 12B illustrate the appearance of attachment of the solar cell module group 10 to the main body part 20 according to modified example 2. FIG. 12A illustrates the appearance when a guide 121b is slid along a guide rail 211b. FIG. 12B illustrates the appearance when the guide 121b is pushed along the guide rail 211b to a specific position (innermost part), a connector 122b and a connector 212b are connected, and attachment of the solar cell module group 10 to the main body part 20 is complete.

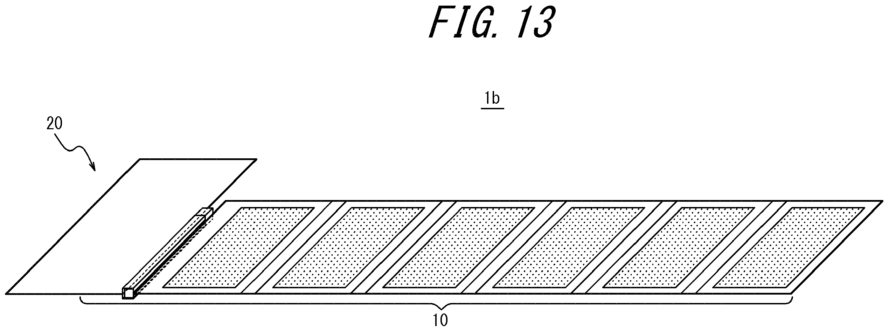

FIG. 13 illustrates the appearance when the solar cell module group 10 is connected to the main body part 20 according to modified example 2 in a case in which the solar cell module group 10 includes a plurality of solar cell modules 11.

### (Modified example 3)

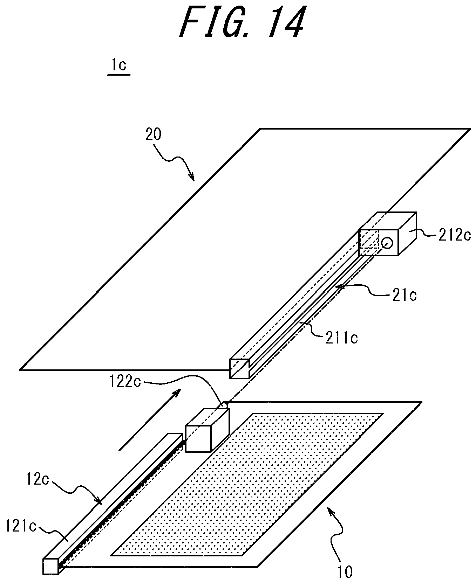

FIG. 14 illustrates configuration of a photoelectric conversion device 1c according to modified example 3.

Modified example 3 is an example in which the shape of a connector 212c of a main body part IF 21c is larger than the internal diameter of a guide rail 211 c of the main body part IF 21c.

In such a situation, a configuration may be adopted in which a connector 122c of a solar cell module IF 12c is separated from a guide 121c of the solar cell module IF 12c as illustrated in FIG. 14.

Through a configuration such as illustrated in FIG. 14, the photoelectric conversion device 1c according to modified example 3 enables the connector 212c to be made larger than the internal diameter of the guide rail 211 c without being restricted by the shape of the guide rail 211c.

### (Modified example 4)

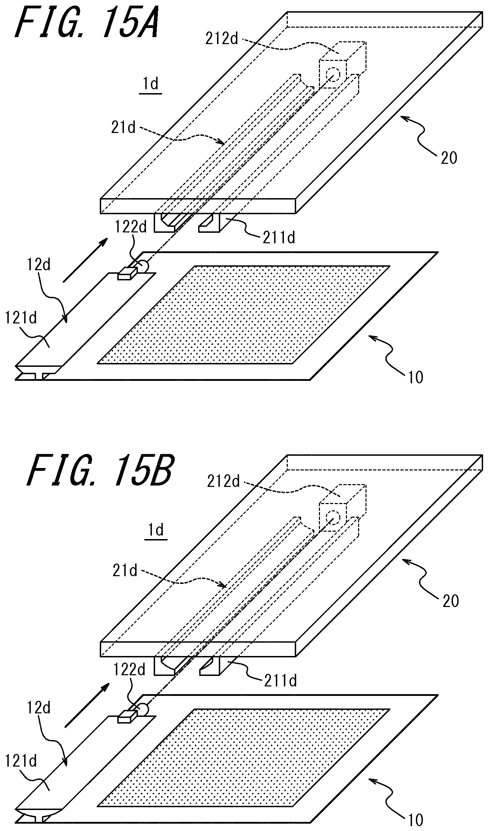

FIGS. 15A and 15B illustrate configuration of a photoelectric conversion device 1d according to modified example 4.

In the example illustrated in FIG. 15A, a guide 121d has a cross-sectional shape that is an inverted trapezoid having a long upper edge and short lower edge. In the example illustrated in FIG. 15B, the guide 121d has a cross-sectional shape that is a semicircle. In the configurations illustrated in FIGS. 15A and 15B, a guide rail 211d has a shape corresponding to the guide 121d.

By adopting a configuration in which the guide 121d has a cross-sectional shape that is vertically asymmetric, it is possible to prevent reverse insertion in which the solar cell module group 10 is inserted into the main body part 20 with the front and rear thereof reversed.

Moreover, the examples illustrated in FIGS. 15A and 15B are examples in which the guide rail 211d and connector 212d are not in an integrated form. Although this configuration differs from the configuration in the first embodiment in which each of the guide rails 211 is integrated with the corresponding connector 212, the configurations illustrated in FIGS. 15A and 15B are merely examples, and a configuration in which the guide rail 211d and the connector 212d are integrated may also be adopted in the configurations illustrated in FIGS. 15A and 15B. Moreover, in the first embodiment illustrated in FIG. 3, each of the guide rails 211 may be provided separately from the corresponding connector 212. The same also applies to the other modified examples.

### (Modified example 5)

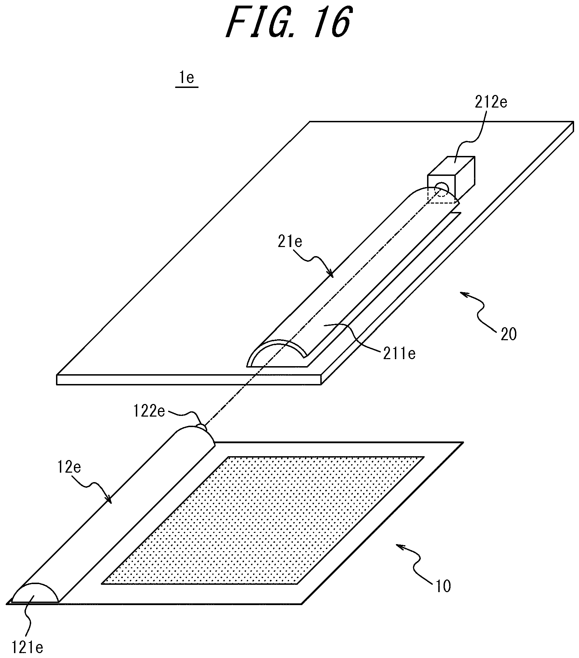

FIG. 16 illustrates configuration of a photoelectric conversion device 1e according to modified example 5.

In the example illustrated in FIG. 16, a guide 121e has a cross-section with a semicircular shape. Moreover, a guide rail 211e has a shape corresponding to the guide 121e and includes a guide groove at the side surface thereof.

This configuration enables reduction of the height direction thickness of the guide rail 211e, which is beneficial in a situation in which a thin configuration is adopted for the main body part 20.

### (Modified example 6)

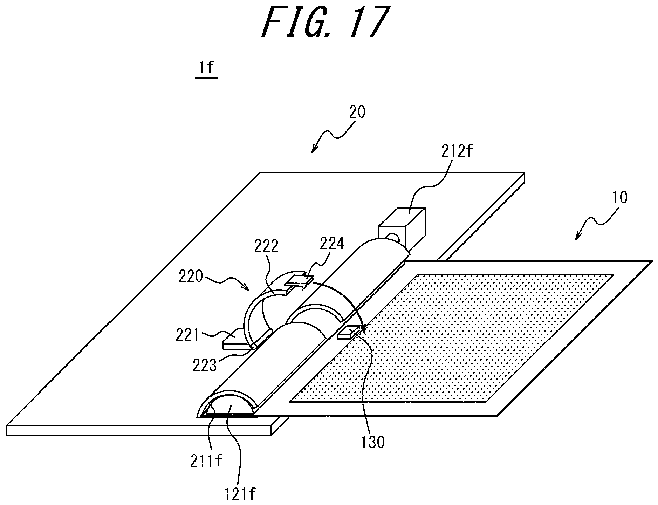

FIG. 17 illustrates configuration of a photoelectric conversion device 1f according to modified example 6.

In the example illustrated in FIG. 17, a securing reinforcement member 220 is provided to secure a guide 121f to the main body part 20. The securing reinforcement member 220 includes a supporting portion 221 that fixes the securing reinforcement member 220 on the main body part 20, a securing portion 222 that presses against and secures the guide 121f, a shaft portion 223 that mechanically connects the supporting portion 221 and the securing portion 222 such that the securing portion 222 is rotatable, and a locking portion 224 disposed at a tip of the securing portion 222. In a state in which the solar cell module group 10 is attached to the main body part 20, the securing reinforcement member 220 presses against and secures the guide 121f through the securing portion 222 as a result of the locking portion 224 being locked into a lock receiving portion 130 disposed on the solar cell module group 10.

By adopting this configuration, the solar cell module group 10 can be held more securely after being attached to the main body part 20.

The securing reinforcement member 220 is positioned partway along a guide rail 211f and may be at any position that is suitable for securing the guide 121f.

Although FIG. 17 illustrates an example of configuration in which one securing reinforcement member 220 is provided, a configuration in which a plurality of securing reinforcement members 220 is provided on the main body part 20 may be adopted. The guide 121f can be held more securely when a plurality of securing reinforcement members 220 is provided.

### (Modified example 7)

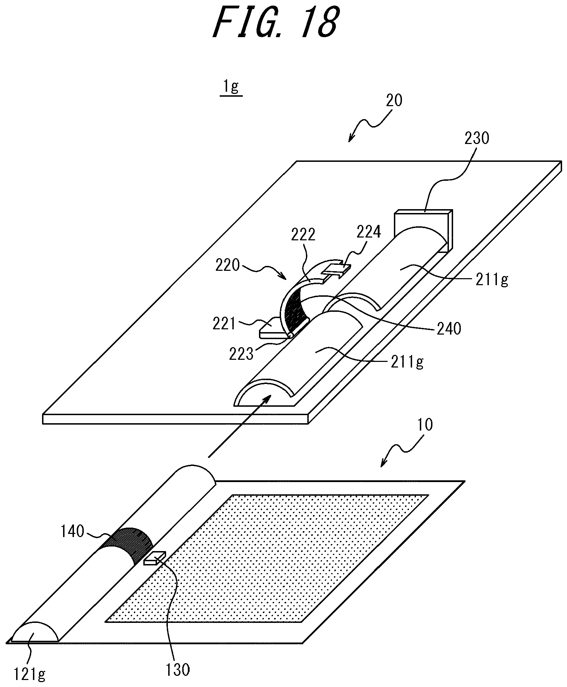

FIG. 18 illustrates configuration of a photoelectric conversion device 1g according to modified example 7.

Modified example 7 is a configuration in which the securing reinforcement member 220 in modified example 6 illustrated in FIG. 17 serves both to secure a guide 121g and also to electrically connect the guide 121g to the main body part 20.

In the example illustrated in FIG. 18, an electrical connection portion 240 is disposed at the inside of the securing portion 222 and an electrical connection portion 140 is disposed on the guide 121g at a position at which the guide 121g is secured by the securing reinforcement member 220. As a result, when the guide 121g is secured through the securing reinforcement member 220, the guide 121g (solar cell module group 10) and the main body part 20 become electrically connected through a contacting portion of the electrical connection portion 240 and the electrical connection portion 140.

By adopting this configuration, it is not necessary to provide a connector at the end of a guide rail 211g. Moreover, when the guide 121g becomes securely held through the securing reinforcement member 220, electrical connection of the guide 121g and the main body part 20 can be simultaneously achieved.

In the configuration illustrated in FIG. 18, the position of the guide 121g when the solar cell module group 10 is attached to the main body part 20 may be determined by a positioning portion 230.

### (Modified example 8)

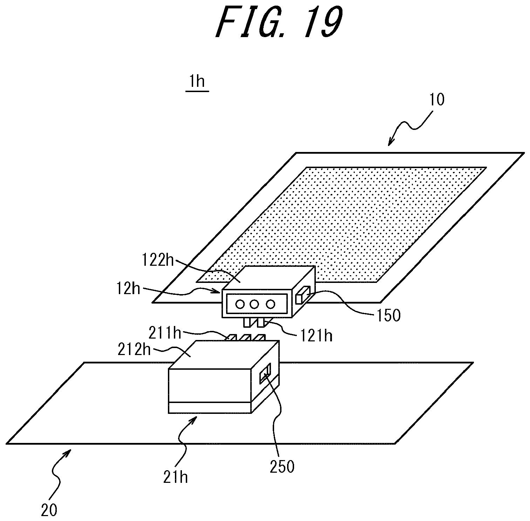

FIG. 19 illustrates configuration of a photoelectric conversion device 1h according to modified example 8.

Modified example 8 is a configuration in which a guide 121h is reduced in size in accordance with the shape of a connector 122h and in which a guide rail 211h is reduced in size in accordance with the shape of a connector 212h. Moreover, a push-type lock mechanism 150 is disposed at a side part of the connector 122h and a hole 250 into which the lock mechanism 150 fits is disposed at a side part of the connector 212h. The hole 250 is disposed at a location at which the lock mechanism 150 is positioned when the connector 122h is inserted into the connector 212h.

By providing the guide 121h and the guide rail 211h respectively on the connector 122h and the connector 212h in this manner, insertion can be performed easily and without error even in the case of a small connector since the connector 122h can be guided along an insertion path formed by the guide rail 211h. This configuration also enables deformation prevention, breaking prevention, improved convenience, and so forth with respect to the connector 122h and the connector 212h.

Moreover, through inclusion of the lock mechanism 150 and the hole 250 such as illustrated in FIG. 19, detachment of the connector 122h from the connector 212h can be prevented.

Next, examples of use of the photoelectric conversion device 1 are described.

### (First example of use)

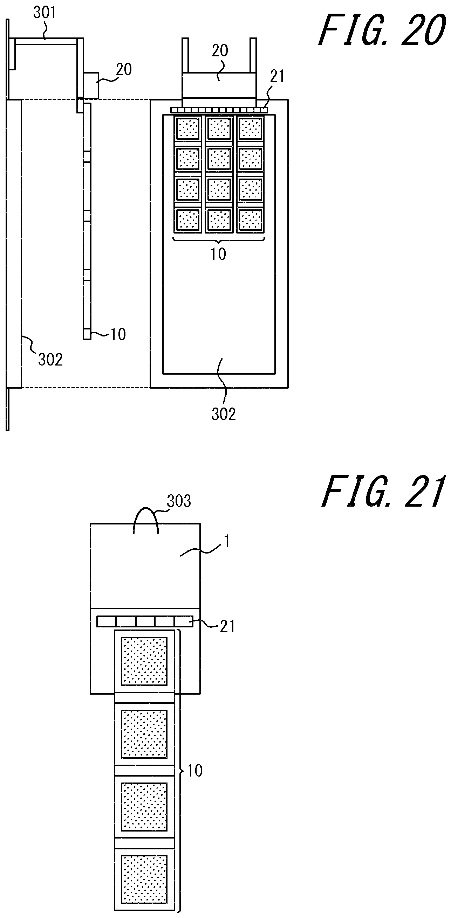

When a user is at home, the photoelectric conversion device 1 may, for example, be set up near a window 302, through a support 301, in a state in which solar cell module groups 10 are attached to the interface 21 as illustrated in FIG. 20. In a situation in which the solar cell module groups 10 are, for example, opened out in a plane on a desk, or the like, for use, the solar cell module groups 10 take up space, making the photoelectric conversion device 1 inconvenient to use. Therefore, supporting the photoelectric conversion device 1 (solar cell module groups 10) in a suspended manner as illustrated in FIG. 20 enables space-saving during set up.

Moreover, when the user goes out, the user may take some of the solar cell module groups 10 set up near the window with them as necessary, and may attach these solar cell module groups 10 to the interface 21 as illustrated in FIG. 21 during use. This is one example of use of the photoelectric conversion device 1 that is envisaged.

Note that the photoelectric conversion device 1 may include a supporting portion 303 (support means) for supporting the photoelectric conversion device 1 as illustrated in FIG. 21.

By providing the photoelectric conversion device 1 with the supporting portion 303, the photoelectric conversion device 1 (solar cell module groups 10) can be supported in a suspended state even in a situation such as when the user goes out.

Moreover, since solar cell module groups 10 can be used by being detached from and attached to the main body part 20 as described above, the following effect is achieved in a situation in which a solar cell module group 10 having improved photoelectric conversion efficiency is developed.

For example, in a situation in which the photoelectric conversion efficiency of a solar cell module group 10 is doubled compared to the conventional photoelectric conversion efficiency, the main body part 20 can be supplied with the same electrical power as conventionally supplied even when a solar cell module group 10 including half the number of solar cell modules 11 that are conventionally included is attached to the main body part 20. Moreover, in a situation in which the photoelectric conversion efficiency of a solar cell module group 10 is doubled compared to the conventional photoelectric conversion efficiency, the main body part 20 can be supplied with double the electrical power that is conventionally supplied when a solar cell module group 10 including the same number of solar cell modules 11 that are conventionally included is attached to the main body part 20.

### (Second example of use)

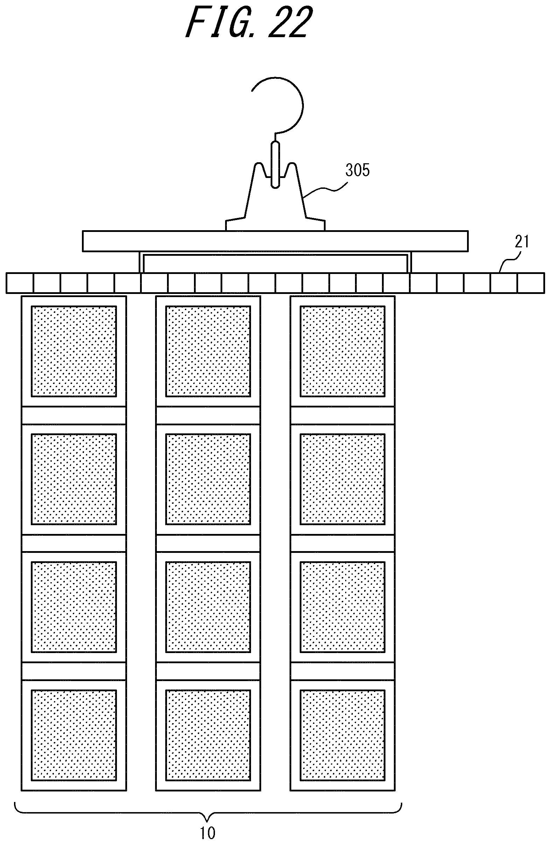

The photoelectric conversion device 1 may include a hanger-shaped suspending member 305 that supports the photoelectric conversion device 1 as illustrated in FIG. 22 with solar cell module groups 10 attached to the interface 21 in a suspended state.

In a situation in which the photoelectric conversion device 1 is supported by the support 301 set up near the window 302 as illustrated in FIG. 20, the set-up position of the photoelectric conversion device 1 is limited to near the window 302. In contrast, by providing the suspending member 305 that supports the photoelectric conversion device 1 as illustrated in FIG. 22, the user can set up the photoelectric conversion device 1 more freely.

In the present embodiment, solar cell module groups 10 can be easily attached to and detached from the interface 21 of the photoelectric conversion device 1 as previously described. Therefore, so long as compatibility between the solar cell module IF 12 and the interface 21 is ensured, various types of solar cell module groups 10 (for example, differing in terms of manufacturer, suppliable electrical power, or type of solar cell modules 11) can be connected interchangeably, which enables improvement of convenience. Moreover, in a situation in which a structure corresponding to the main body part 20 of the photoelectric conversion device 1 is provided at a location that the user visits while out, the user only needs to carry the necessary solar cell module groups 10, which enables improvement of convenience.

It should be noted that although the presently disclosed photoelectric conversion device has been described herein based on the drawings and embodiments, various modifications and revisions can easily be made by persons of ordinary skill in the technical field based on this disclosure. Therefore, such modifications and revisions should also be considered to be included within the scope of this disclosure. For example, the functions of blocks, or the like, may be rearranged so long as no logical contradiction arises, and blocks may be combined as a single block or may be split up.

### INDUSTRIAL APPLICABILITY

According to this disclosure, a solar cell module can be easily connected to a main body capable of supplying electrical power to an external device and more reliable connection between the solar cell module and the main body can be achieved.

### REFERENCE SIGNS LIST

- 1: photoelectric conversion device
- 10: solar cell module group
- 11: solar cell module
- 12: solar cell module interface
- 13: solar cell module set
- 20: main body part
- 21: interface
- 22: step-up circuit section
- 23: solar cell voltage detection section
- 24: AC adapter voltage detection section
- 25: rechargeable battery
- 26: external interface
- 27: charge/discharge control circuit
- 28: controller
- 30: AC adapter
- 31: power outlet
- 32: AC/DC converter
- 121: guide
- 122: connector
- 130: lock receiving portion
- 140: connector
- 150: lock mechanism
- 211: guide rail
- 212: connector
- 220: securing reinforcement member
- 221: supporting portion
- 222: securing portion
- 223: shaft portion
- 224: locking portion
- 230: positioning portion
- 240: connector
- 250: hole
- 301: support
- 302: window
- 303: supporting portion
- 305: suspending member

## Claims

1. A photoelectric conversion device comprising:
a photoelectric conversion module group including a first connection means; and
a main body part including a second connection means that is mechanically and electrically connectable to the first connection means, wherein
the first connection means includes a first connecting portion and a first connector,
the second connection means includes a second connecting portion that is configured to slide against and engage with the first connecting portion and a second connector that is configured to connect to the first connector in a state in which the first connecting portion is at a specific position, and
one of the first connecting portion and the second connecting portion is a guide rail and the other of the first connecting portion and the second connecting portion is a guide that slides against and engages with the guide rail.

2. The photoelectric conversion device according to claim 1, wherein
the first connecting portion and the first connector are bound together as an integrated structure.

3. The photoelectric conversion device according to claim 1 or 2, wherein
the second connecting portion and the second connector are bound together as an integrated structure.

4. The photoelectric conversion device according to any one of claims 1 to 3, wherein
the photoelectric conversion module group includes a plurality of photoelectric conversion modules in cascade connection.

5. The photoelectric conversion device according to any one of claims 1 to 4, wherein
in a case in which the first connecting portion is a guide and the second connecting portion is a guide rail, the first connector is disposed at a tip of the first connecting portion and the second connector is disposed at an innermost part of the second connecting portion, and
in a case in which the first connecting portion is a guide rail and the second connecting portion is a guide, the first connector is disposed at an innermost part of the first connecting portion and the second connector is disposed at a tip of the second connecting portion.

6. The photoelectric conversion device according to any one of claims 1 to 5, wherein
the first connection means includes a plurality of the first connecting portion and a plurality of the first connector, and
the second connection means includes a plurality of the second connecting portion and a plurality of the second connector.

7. The photoelectric conversion device according to any one of claims 1 to 6, wherein
the guide has a cross-sectional shape that is vertically asymmetric.

8. The photoelectric conversion device according to any one of claims 1 to 7, wherein
the guide rail has a guide groove in a side surface at one side thereof.

9. The photoelectric conversion device according to any one of claims 1 to 8, wherein
the first connecting portion is a guide and the second connecting portion is a guide rail, and
a securing reinforcement member that is configured to secure the first connecting portion is disposed on the main body part.

10. The photoelectric conversion device according to claim 9, wherein
the securing reinforcement member and the first connecting portion are electrically connected through a contacting portion of the securing reinforcement member and the first connecting portion.

11. The photoelectric conversion device according to any one of claims 1 to 4, wherein
the first connector includes a lock mechanism that is configured to lock the first connection means and the second connection means in a state in which the first connection means and the second connection means are mechanically and electrically connected.

12. The photoelectric conversion device according to any one of claims 1 to 11, further comprising
a support means configured to support the photoelectric conversion device in a suspended manner.

13. The photoelectric conversion device according to any one of claims 1 to 12, wherein
the first connector and the second connector include at least one electrode terminal.

14. The photoelectric conversion device according to any one of claims 1 to 13, wherein
the photoelectric conversion module group includes a photoelectric conversion module that is an organic solar cell module.

15. The photoelectric conversion device according to any one of claims 1 to 13, wherein
the photoelectric conversion device is an organic solar cell power generating device.

16. The photoelectric conversion device according to any one of claims 1 to 13, wherein
the photoelectric conversion module group includes a photoelectric conversion module that is an inorganic solar cell module.

17. The photoelectric conversion device according to any one of claims 1 to 13, wherein
the photoelectric conversion device is an inorganic solar cell power generating device.

18. The photoelectric conversion device according to any one of claims 1 to 17, wherein
the photoelectric conversion module group includes a photoelectric conversion module that is a solar cell module in which at least one electrode has a plastic material as a base.
